(19) Europäisches Patentamt
European Patent Office
Office européen des brevets

(11) **EP 2 696 207 A1**

(12) **EUROPEAN PATENT APPLICATION**
published in accordance with Art. 153(4) EPC

(43) Date of publication:
**12.02.2014 Bulletin 2014/07**

(51) Int Cl.:
***G01R 29/12*** *(2006.01)*

(21) Application number: **12803313.1**

(22) Date of filing: **11.04.2012**

(86) International application number:
**PCT/JP2012/059858**

(87) International publication number:
**WO 2012/176536 (27.12.2012 Gazette 2012/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.06.2011 JP 2011136195**

(71) Applicant: **National Institute of Advanced Industrial Science and Technology Tokyo 100-8921 (JP)**

(72) Inventors:
• **KIKUNAGA Kazuya**
**Tosu-shi**
**Saga 841-0052 (JP)**
• **NONAKA Kazuhiro**
**Tosu-shi**
**Saga 841-0052 (JP)**

(74) Representative: **Prüfer & Partner GbR**
**European Patent Attorneys**
**Sohnckestrasse 12**
**81479 München (DE)**

(54) **APPARATUS FOR MEASURING QUANTITY OF STATIC ELECTRICITY, AND METHOD FOR MEASURING QUANTITY OF STATIC ELECTRICITY**

(57) [Problem to be Solved]
To provide a static-electricity-quantity measuring apparatus and a static-electricity-quantity measuring method which are optimum for a manufacturing site under a difficult-to-measure situation and measure the quantity of static electricity of electronic parts, machine parts, etc. simply with high accuracy.
[Solution] A static-electricity-quantity measuring apparatus 1 of the present invention has: a receiving unit 2, which receives virtual electromagnetic waves generated by vibrations applied to a measured object 10; a measuring unit 3, which measures at least one of the intensity, frequency, and phase of the virtual electromagnetic waves received by the receiving unit 2; and a calculating unit 4, which calculates the quantity of static electricity of the measured object 10 based on the measurement result of the measuring unit 3.

FIG. 4

RECEIVING UNIT 2

MEASURING UNIT 3

CALCULATING UNIT 4

STATIC-ELECTRICITY-QUANTITY MEASURING APPARATUS

EP 2 696 207 A1

**Description**

Technical Field

The present invention relates to a static-electricity-quantity measuring apparatus capable of highly accurately measuring the quantities of static electricity possessed by parts used in manufacturing steps at various manufacturing sites of semiconductor manufacturing, electronic device manufacturing, precision machine manufacturing, transporting machine manufacturing, chemical product manufacturing, food manufacturing, etc. without increasing load or labor in the manufacturing steps.

Background Art

Japan has various manufacturing industries supporting the base of industries such as semiconductor manufacturing, electronic device manufacturing, precision machine manufacturing, transporting machine manufacturing, chemical product manufacturing, and food manufacturing. Conventionally, mostly in big companies, a series of flows of research, development, design, manufacturing, qualitycontrol and sales has been carried out in a manner of vertical integration. Such vertical integration type companies have been in an environment that it has been easy to carry out feedback and feedforward in the same company for insufficient quality and yield reduction of manufactured products (finished products and semi-finished products), which can happen at manufacturing sites, and taking measures in development and designing.

On the other hand, recently, a manufacturing department (i.e. , manufacturing factory) has been made into a subsidiary company in the same company because of the problem of manufacturing cost, and a manufacturing company which carries out only contracted manufacturing has appeared. Similarly, for example, fabless companies, which carries out only research and development but does not carry out manufacturing, are doing well mainly in electric fields, information communication fields, etc.

In this manner, in the manufacturing industries of today, developing and designing areas and actual manufacturing areas are often dissociated from each other in terms of physical, time, technique, and humans. When there is such dissociation, it is difficult to carry out feedback and feedforward between manufacturing sites and developing sites about insufficient quality and yield deterioration caused at the manufacturing sites. Due to this difficulty, the manufacturing power of the manufacturing industries of Japan (including contracted manufacturing companies which only undertakes manufacturing, manufacturing subsidiary companies, fabless companies, etc.) may have been reduced.

Deterioration factors of quality and yield at manufacturing sites are various. The factors include inevitable factors such as readiness of design and manufacturing, the level of skills at manufacturing sites, flows of manufacturing steps, manufacturing equipment, and human skills, and one of the factors which are often overlooked is static electricity. In manufacturing steps of electronic devices or precision machine fields, a plurality of electronic parts or machine parts are assembled at a manufacturing line, thereby manufacturing semi-finished products and finished products. The electronic parts or machine parts used in the manufacturing of the semi-finished products and the finished products are often electrified with static electricity due to various factors. When the thus-electrified electronic parts or machine parts are used in assembly of finished products or semi-finished products in manufacturing steps, discharge (ESD) of the static electricity sometimes causes failure or destruction of the electrified parts, as a matter of course, and also other unelectrified parts which are mounted on finished products or semi-finished products, the finished products, and the semi-finished products. The failure and destruction of such parts, finished products, and semi-finished products directly leads to deterioration of quality and yield.

As specific examples, semiconductor integrated elements such as IC and LSI and electronic boards on which they are mounted are extremely vulnerable to static electricity. At manufacturing sites, these elements and electronic boards are easily electrified with static electricity due to contact, peel-off, plasma, etc., and ESD destruction easily occurs due to contact with another element or worker. This leads to destruction of electronic elements flowing on a manufacturing line and failure of electronic boards on which the electronic elements are mounted. In some cases, fire may occur due to discharge, and the static electricity at manufacturing sites cause various problems.

At current manufacturing sites, with respect to such a problem of static electricity, two measures of (1) prevention and (2) efforts of electricity neutralizing such as use of electricity-preventing uniforms and connection of ground wires to workers have been mainly carried out. However, even when the efforts of prevention and electricity neutralization are carried out, electrification of static electricity cannot be always prevented, and failure or destruction caused by the static electricity cannot be detected or predicted. This is for a reason that these measures are not the measures which are carried out after measuring which electronic part or machine part has been electrified.

In addition to that, at manufacturing sites, electrification of static electricity can be caused at various scenes. In a case of a manufacturing line of electronic devices, the scenes include: (1) when electronic elements or electronic parts housed in reels or packages are taken out and put on a line to flow, (2) when the electronic elements or electronic parts which have flowed on the line are taken out by a machine or human power, (3) when the taken out electronic elements or electronic parts are mounted on electronic boards, (4) when each of the electronic boards on which the various electronic parts are mounted is transported to a next step, (5) when the plurality of electronic boards are built in a chassis, etc. Electrification of the electronic parts or electronic boards can be caused by contact between a machine and an apparatus or contact with a human body in an environment in which a plurality of objects are brought into contact with each other like above described (1) to (5). When the width of such electrification variations of static electricity is taken into consideration, only working in the electricity-preventing uniforms is not a sufficient measure.

In addition, in which one of these (1) to (5) failure, etc. due to static electricity are caused is unknown, which leads to incapability of specifying the cause(s) of quality deterioration or yield deterioration after manufacturing of final products (finished products, semi-finished products) at a production site is finished. More specifically, it is difficult to specify if the cause(s) of the deterioration of quality or yield of the manufactured products is <1> static electricity or not and <2> if static electricity is a cause, in which manufacturing step the static electricity has been generated.

Therefore, at a manufacturing site, it is necessary for the manufacturing site to measure the electrified quantity of static electricity of the electronic parts or machine parts (as a matter of course, including products on which they are mounted).

In order to measure the electrified quantity of such static electricity, various methods have been proposed (for example, see Patent Publication 1 to 3 and Non-Patent Publication 1 to 5).

Citation List

Patent Publication

Patent Publication 1: Japanese Patent Publication No. 2001-522045
Patent Publication 2: International Republished Publication No. W02007-055057
Patent Publication 3: Japanese Patent Publication No. 2004-512528

Non Patent Publication

Non Patent Publication 1: H. Onomae: Kagoshima prefectural Institute of Industrial Technology research report, No. 20, pp. 57 to 63 (2006)
Non Patent Publication 2: A. Kanno, K. Sasagawa, T. Shiozawa, and M. Tsuchiya: Optics Express 18 (2010) 10029 to 10035
Non Patent Publication 3: A. Kumada, A. Iwata, K. Ozaki, M. Chiba, K. Hidaka: J. Appl. Phys. 92 (2002) 2875
Non Patent Publication 4: E. Eisenmenger, M. Haardt: Solid St. Comm. 41 (1982) 2769 to 2775
Non Patent Publication 5: T. Maeda, Y. Oki, A. Nishikata, T. Maeno: Trans. Inst. Elect. Engnr. Jpn. A 126 (2006) 185 to 190

Summary of Invention

Technical Problems

Conventional techniques have mainly proposed below five methods for the measurement of the quantity of static electricity.

(Method 1) Faraday Cage

A Faraday cage measures the quantity of electrification of measured object by housing the measured object in a cage, which can measure charge, and measuring the quantity of charge while considering the measured object as a capacitor.

However, in the case of the Faraday cage, measured objects have to be housed in the cage one by one. At a manufacturing site where several tens of thousands to several millions of electronic parts or machine parts sequentially flow on a line, this is extremely unpractical for practice. The Faraday cage is suitable for a case in which the quantities of electrification of a small number of objects have to be carefully measured, and the Faraday cage is not suitable for factories of electronic devices, transporting devices, chemical products, foods, etc. of which condition is mass production.

(Method 2) Surface Electrometer

A surface electrometer measures the quantity of static electricity by measuring the quantity of electric fields of a measured object while bringing a probe close to the surface of the measured object. For example, Non-Patent Publication 1 discloses techniques of measuring the quantity of static electricity by the surface electrometer.

However, the surface electrometer has to bring the probe close to the measured object and requires labor of a worker. If the skills of the worker is low, the measured object may be physically broken when the probe is brought close thereto. If there is dissociation between the size of the measured obj ect and a range measured by the probe, there is a problem that the accuracy of the measured quantity of static electricity is deteriorated. Furthermore, since electronic parts, etc. flow in various forms at a factory line, there is a problem that the probe is disturbed by other devices and cannot be accurately brought close to there.

(Method 3) Method using Pockels Effect

The Pockels effect is a phenomenon that, when an electric field is applied isotropic crystals of a dielectric substance from outside, the refraction index of light is changed in proportion to the electric field. By utilizing this, a predetermined medium (Pockels crystalline body) is installed at a surface of a measured object, and static electricity is measured by detecting the refraction index of reflected light or transmitted light when the medium is irradiated with light. For example, Non-Patent Publication 2 discloses techniques of static electricity measurement using this Pockels effect.
However, in order to use the Pockels effect, a flat medium has to be installed near the surface of the measured object. This is not practical for application to a manufacturing line on which many electronic parts or machine parts flow in various forms. As a matter of course, a measuring worker has to be skillful. Also, there is a problem that accuracy of the measured quantity of static electricity is lowered due to working accuracy of radiated light, detection of reflected light, etc.

(Method 4) Method using Kerr Effect

The Kerr effect is a phenomenon that, when an electric field is applied to a substance from outside, the refraction index of light is changed in proportion to the square of the electric field, and static electricity can be measured by measuring the electro-optical characteristics thereof. For example, Non-Patent Publication 3 discloses static electricity measuring techniques using the Kerr effect of a gas.
However, with the Kerr effect, it is extremely difficult to detect the change, it is extremely difficult to measure the quantity of static electricity of minute electronic parts, etc., and it is difficult to apply this method to a manufacturing site.

(Method 5) Scanning Probe Microscope

A scanning probe microscope measures the quantity of static electricity while scanning a probe with respect to a measured object. For example, Patent Publication 1 discloses a static-electricity detecting technique provided with a cantilever for an electrostatic force microscope.
However, the scanning probe microscope has problems that working labor is large and the apparatus has a large scale.

(Method 6) Technique of Measuring Electrification Distribution in Solid Substance

Non-Patent Publications 4 and 5 disclose techniques of measuring the distribution of electrification in a solid substance. However, these techniques require an electrode to abut a measured object. Therefore, it is difficult to apply this method to a manufacturing site, and this method has similar problems.
As described above, the various methods proposed in the conventional techniques have below problems.

(Problem 1)

There is a problem that many apparatuses and instruments are required and that workers are required to be skillful. Particularly, there is a problem that manufacturing cost is increased (cost is increased more than a yield reducing effect) since a dedicated worker who measures static electricity is required other than workers for manufacturing at a manufacturing site.

(Problem 2)

The probe, medium, etc. have to be brought close to the measured object by a limited angle, distance, etc., and there is a problem that application to a manufacturing site with various obstacles such as lines, apparatuses, etc. is difficult.

(Problem 3)

Due to Problems 1 and 2, there is a problem that it is difficult to measure the quantity of static electricity of each of a massive amount of electronic parts, etc. at a manufacturing site in which the massive amount of electronic parts or machine parts flow.

(Problem 4)

In a case of a poorly balanced measurement environment, which is not ideal, such as a case without other electrified bodies or grounding therearound, there is a problem that measurement accuracy is bad.
Under such circumstances, Patent Publication 2 and Patent Publication 3 have been proposed as techniques for measuring electric characteristics and mechanical characteristics utilizing sound waves, although these are not for measuring static electricity.
Patent Publication 2 discloses the techniques of measuring electric characteristics, mechanical characteristics, etc. of objects by utilizing electromagnetic waves by sound waves. However, an object of Patent Publication 2 is for human bodies and living bodies in a medical-care or treatment apparatus. In medical care or treatment, the scale of apparatuses and labor can be increased since time and cost can be taken for the human bodies and living bodies serving as objects to measure the physical properties thereof. Therefore, it is difficult to apply the techniques of Patent Publication 2 to a manufacturing site. Particularly, Patent Publication 2 does not discloses measurement of static electricity, but only discloses a rough idea of measuring electric characteristics by using electromagnetic waves. Therefore, the techniques disclosed in Patent Publication 2 also have (Problem 1) to (Problem 4) as well as the Method 1 to Method 5 of the conventional techniques.

Patent Publication 3 discloses techniques of measuring the physical properties of an object by disposing a measured object in a fluid and measuring an electric signal generated in the fluid by sound waves. As a matter of course, the techniques disclosed in Patent Publication 3 require installation of the fluid, disposing of the object and electrodes, etc. and have (Problem 1) to (Problem 4) as well as the Method 1 to Method 5 of the conventional techniques. Each of Patent Publication 2 and Patent Publication 3 does not consider techniques of measuring the quantity of static electricity of electronic parts, etc. at a manufacturing site in which the massive amount of electronic parts or machine parts flow in complex forms and does not consider the techniques which can be applied thereto.

As described above, the conventional techniques have problems that it is difficult to highly accurately measure the quantity of static electricity of many electronic parts, machine parts, etc. without generating measuring labor and measuring cost at a manufacturing site in which the massive amount of electronic parts and/or machine parts flow or are mounted in various forms.

In view of the above described problems, it is an object of the present invention to provide a static-electricity-quantity measuring apparatus and a static-electricity-quantity measuring method which are optimum for a manufacturing site under a difficult-to-measure situation and measure the quantity of static electricity of, electronic parts, machine parts, etc. simply with high accuracy.

Solution to Problems

In view of the above described problems, a static-electricity-quantity measuring apparatus of the present invention has: a receiving unit, which receives virtual electromagnetic waves generated by vibrations applied to a measured obj ect; a measuring unit, which measures at least one of the intensity, frequency, and phase of the virtual electromagnetic waves received by the receiving unit; and a calculating unit, which calculates the quantity of static electricity of the measured object based on the measurement result of the measuring unit.

Advantageous Effects of Invention

The static-electricity-quantity measuring apparatus of the present invention can measure the quantity of the static electricity of electronic parts, etc. without approaching or abutting while limiting the distance, angle, etc. with respect to the electronic part or machine part. Therefore, influence of apparatuses, equipment, etc. around the electronic part or machine part serving as a measured object is small, and the quantities of static electricity of many objects can be measured.

The static-electricity-quantity measuring apparatus can measure the quantity of static electricity by the virtual electromagnetic waves generated when the whole object electrified with static electricity is vibrated. Therefore, measurement accuracy is extremely high. Particularly, the vibration applying unit, which generates the virtual electromagnetic waves, and the measuring unit of electromagnetic waves can be separated from each other to constitute the apparatus. Therefore, physical limitations at manufacturing sites can be easily handled.

By virtue of the combination of these effects, the static-electricity-quantity measuring apparatus of the present invention can be easily applied to manufacturing sites and also can accurately measure the quantity of the static electricity of many objects. Furthermore, static electricity serving as one cause of quality deterioration or yield deterioration at manufacturing sites can be easily specified. As a result, a manufacturing site alone can specify the cause and measure of the quality deterioration or yield deterioration, and improvement and upgrading of the function and production capacity of a manufacturing site which has been dissociated from a development site (since it is a contracted manufacturing company, manufacturing subsidiary company, fabless company, etc.) can be realized.

Such quality/production improvement of a manufacturing factory brings advantages also to the manufacturing factory and enhances independence of developing and designing steps which have been dissociated from the manufacturing factory. Therefore, as a result, technology bases of various manufacturing industries of a vertical integration type, a horizontal labor dividing type, etc. can be improved.

Brief Description of the Drawings

[Figure 1] FIG. 1 shows explanatory drawings showing static-electricity-quantity measurement by a surface electrometer as a reference example of the present invention.
[Figure 2] FIG. 2 is an explanatory drawing showing static-electricity-quantity measurement by a surface electrometer as a reference example of the present invention.
[Figure 3] FIG. 3 shows explanatory drawings showing static-electricity-quantity measurement by a surface electrometer as a reference example of the present invention.
[Figure 4] FIG. 4 is a block diagram of a static-electricity-quantity measuring apparatus of a first embodiment of the present invention.
[Figure 5] FIG. 5 is an explanatory drawing showing generation of virtual electromagnetic waves of a measured object in the first embodiment of the present invention.
[Figure 6] FIG. 6 is a schematic drawing showing an installation state of the static-electricity-quantity measuring apparatus 1 of the first embodiment of the present invention.

[Figure 7] FIG. 7 shows graphs showing relations of the measured intensities of the electromagnetic waves and surface potentials of measured objects 10 in the first embodiment of the present invention.

[Figure 8] FIG. 8 shows graphs showing phases measured in the first embodiment of the present invention.

[Figure 9] FIG. 9 is an internal block diagram of a calculating unit of a second embodiment of the present invention.

[Figure 10] FIG. 10 is a table showing relations between weighting and the calculated quantity of static electricity in the second embodiment of the present invention.

[Figure 11] FIG. 11 is a block diagram of a static-electricity-quantity measuring apparatus of a third embodiment of the present invention.

[Figure 12] FIG. 12 is a schematic drawing showing individual application and entire application of the third embodiment of the present invention.

[Figure 13] FIG. 13 is a schematic drawing showing a state of vibration application of the third embodiment of the present invention.

[Figure 14] FIG. 14 is an explanatory drawing of sound wave radiation by a speaker in the third embodiment of the present invention.

[Figure 15] FIG. 15 is a schematic drawing showing a state of vibration application in the third embodiment of the present invention.

[Figure 16] FIG. 16 shows a graph showing measurement results in an example of the third embodiment of the present invention.

[Figure 17] FIG. 17 is a graph showing measurement results of the example of the third embodiment of the present invention.

[Figure 18] FIG. 18 is a block diagram of an electrostatic eliminator of a fourth embodiment of the present invention.

[Figure 19] FIG. 19 is a flow chart showing a static-electricity-quantity measuring method according to a fifth embodiment of the present invention. Description of Embodiments

A static-electricity-quantity measuring apparatus according to a first invention of the present invention has:

a receiving unit operable to receive a virtual electromagnetic wave generated by a vibration applied to an electrified measured object; a measuring unit operable to measure at least one of an intensity, frequency, and phase of the virtual electromagnetic wave received by the receiving unit; and a calculating unit operable to calculate the quantity of static electricity of the measured object based on a measurement result of the measuring unit.

By virtue of this configuration, the static-electricity-quantity measuring apparatus can easily and precisely measure the quantities of static electricity of various elements such as parts and products without being limited by a surrounding environment even at a manufacturing site.

In the static-electricity-quantity measuring apparatus according to a second invention of the present invention, in addition to the first invention, the measured object is a product element of any of an electronic part, an electronic element, a semiconductor integrated element, an electronic board, an electronic device, a machine part, a transporting device, a chemical product, food, a drug, and a fiber product used at a manufacturing site.

By virtue of this configuration, the quantities of static electricity of various parts and products, which are problematic if they have static electricity, are measured in advance.

In the static-electricity-quantity measuring apparatus according to a third invention of the present invention, in addition to the second invention, the product element flows on a manufacturing line at a manufacturing site.

By virtue of this configuration, the static-electricity-quantity measuring apparatus can measure the quantity of static electricity of the measured object, which flows on the manufacturing line.

In the static-electricity-quantity measuring apparatus according to a fourth invention of the present invention, in addition to any of the first to third inventions, the calculating unit calculates the quantity of the static electricity of the measured object based on at least one of a correspondence relational expression of the intensity of the virtual electromagnetic wave and the quantity of static electricity and a relational table of the intensity of the virtual electromagnetic wave and the quantity of static electricity.

By virtue of this configuration, the calculating unit can calculate the quantity of static electricity without depending on the size or shape of the measured object. This is for a reason that the virtual electromagnetic wave has a constant frequency, intensity, etc. (although having magnitude based on the vibration) without depending on the size, structure, shape, etc. of the measured object.

In the static-electricity-quantity measuring apparatus according to a fifth invention of the present invention, the calculating unit calculates a reliability value based on amplitude given to the measured object and subjects the quantity of the static electricity calculated based on the intensity of the virtual electromagnetic wave to weighting of the reliability value to calculate the quantity of the static electricity of the measured object.

By virtue of this configuration, the calculating unit can accurately measure the quantity of the static electricity while taking the influence of the surrounding environment on the virtual electromagnetic wave into consideration.

In the static-electricity-quantity measuring apparatus according to a sixth invention of the present invention, in addition to the fifth invention, the reliability value is small if the amplitude given to the measured object is small and is large if the amplitude given to the measured object is large.

By virtue of this configuration, correction by reliability is enabled.

In the static-electricity-quantity measuring apparatus according to a seventh invention of the present invention, in addition to the first to sixth inventions, the calculating unit determines positive/negative of the static electricity electrifying the measured object based on the phase of the virtual electromagnetic wave.

By virtue of this configuration, information necessary for discharge of the static electricity is obtained.

The static-electricity-quantity measuring apparatus according to an eighth invention of the present invention, in addition to any of the first to seventh inventions, further having a vibration applying unit operable to apply the vibration to the measured object.

By virtue of this configuration, the static-electricity-quantity measuring apparatus can also generate the virtual electromagnetic wave.

In the static-electricity-quantity measuring apparatus according to a ninth invention of the present invention, in addition to the eighth invention, if the measured object is a part element, the vibration applying unit applies the vibration to the measured object by at least one of individual application of applying the vibration to the individual measured obj ect transported by a manufacturing line and entire application of applying the vibration to the manufacturing line per se on which the measured object is placed.

By virtue of this configuration, the vibration application matching the situation of the measured object and/or the manufacturing site can be carried out.

In the static-electricity-quantity measuring apparatus according to a tenth invention of the present invention, in addition to the eighth invention, if the measured object is a product on which a plurality of parts are mounted, the vibration applying unit applies the vibration to the product, and the receiving unit directs toward each region of the product.

By virtue of this configuration, the static-electricity-quantity measuring apparatus can measure the quantity of the static electricity of particular parts, etc. contained in a product.

In the static-electricity-quantity measuring apparatus according to an eleventh invention of the present invention, in addition to any of the eighth to tenth inventions, the vibration applying unit determines at least one of amplitude and the number of vibration(s) based on a specification of at least one of the receiving unit and the measuring unit.

By virtue of this configuration, the virtual electromagnetic wave optimized for the specification of the receiving unit and/or the measuring unit is generated.

In the static-electricity-quantity measuring apparatus according to a twelfth invention of the invention, in addition to any of the eighth to eleventh inventions, the vibration applying unit applies the vibration to the measured object by at least one of direct application of applying the vibration to the supporting mount on which the measured object is placed and indirect application of applying a sound wave to the measured object.

By virtue of this configuration, the vibration applying unit can apply the vibration optimized for the environment in which the measured object is placed.

In the static-electricity-quantity measuring apparatus according to a thirteenth invention of the present invention, in addition to any of the eighth to twelfth inventions, the vibration applying unit has a sound-wave generating unit operable to generate a sound wave, and the measured object is directly or indirectly vibrated by the sound-wave generating unit.

By virtue of this configuration, the vibration is more easily applied.

In the static-electricity-quantity measuring apparatus according to a fourteenth invention of the present invention, in addition to the thirteenth invention, the sound-wave generating unit has a focusing function of focusing the sound wave in accordance with the size of the measured object.

By virtue of this configuration, the vibration applying unit can reliably apply the vibration even when the measured object is small.

The static-electricity-quantity measuring apparatus according to a fifteenth invention of the present invention, in addition to any of the eighth to fourteenth inventions, the vibration applying unit has a vibrator installed at an end of the measured object and applies the vibration to the measured object by a vibration of the vibrator.

By virtue of this configuration, the vibration is reliably applied.

An electrostatic eliminator according to a sixteenth invention of the present invention has the static-electricity-quantity measuring apparatus according to any of claims 1 to 15; a displaying unit operable to display the quantity of static electricity measured by the static-electricity-quantity measuring apparatus; and an electricity neutralizing unit operable to remove the static electricity electrifying the measured object.

By virtue of this configuration, parts, etc. having static electricity can be electrically neutralized promptly, and troubles in manufacturing steps can be prevented.

Hereinafter, embodiments of the present invention will be explained by using drawings.

(First Embodiment)

A first embodiment will be explained.

(Reference Example)

First, as a reference example for the first embodiment, problematic points of static-electricity-quantity measurement by a surface electrometer will be explained. A surface electrometer measures the quantity of static electricity by bringing a probe closer to a measured object and is most often used in measurement of the quantity of static electricity in various scenes of today.

(1) Discrepancy Dependency on Areas of Measured Object and Probe

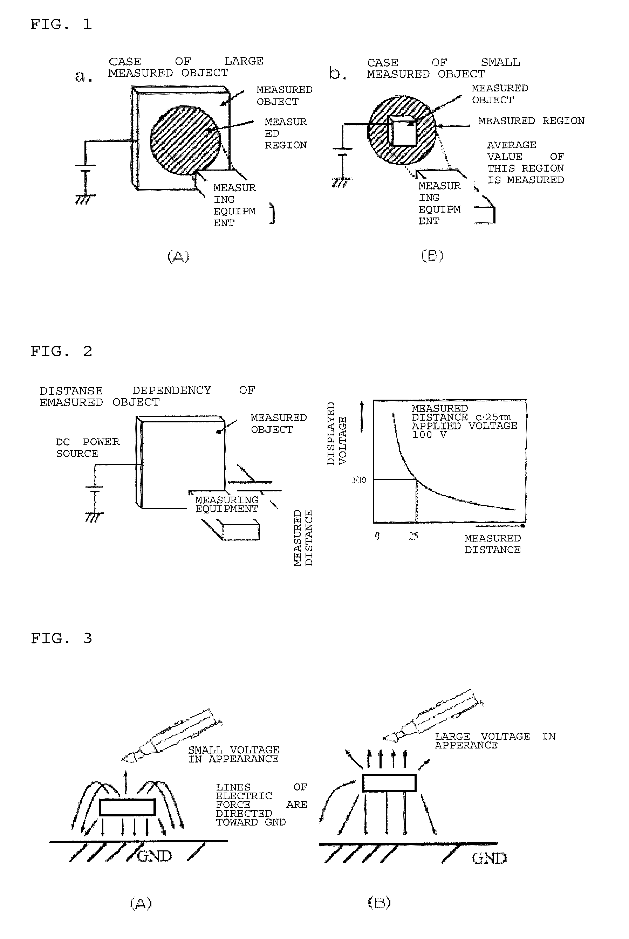

FIG. 1 shows explanatory drawings showing static-electricity-quantity measurement by a surface electrometer as the reference example of the present invention. The surface electrometer measures the quantity of static electricity by bringing a probe closer to a measured object and causing a detecting electrode to receive electrostatic field intensity from an electrified object by electrostatic induction. In this process, the area of the region by which the quantity of static electricity can be measured (measured area) is determined by the distance between the measured object and the probe. The surface electrometer calculates an average value obtained in the measured area as the quantity of static electricity.

If a measured area is smaller than a measured object as shown in FIG. 1 (A), the surface electrometer calculates the average of a partial measured region of the measured object as the quantity of static electricity. However, if a measured area is larger than a measured object as shown in FIG. 1 (B), the surface electrometer calculates the average of the measured region, which is also including a part other than the measured object, as the quantity of static electricity. Therefore, a value smaller than the quantity of the static electricity substantially electrifying the measured object is calculated.

(2) Dependency on Distance between Measured Object and Probe

FIG. 2 is an explanatory drawing showing static-electricity-quantity measurement by a surface electrometer as a reference example of the present invention. As is clear from FIG. 2, the calculated quantity of the static electricity is varied by the distance between a probe and a measured object. At a manufacturing site such as a factory, it is difficult to maintain a constant distance between each measured object and the probe since the shapes of lines and facilities of factories are various.

(3) Dependency on Electric-Field Direction

FIG. 3 shows explanatory drawings showing static-electricity-quantity measurement by a surface electrometer as a reference example of the present invention. FIG. 3 (A) shows a state in which a measured object is close to a ground surface, and FIG. 3 (B) shows a state in which the measured object is distant from the ground surface. When the measured object is close to the ground surface as shown in FIG. 3 (A), electric fields are attracted to the ground surface, and the quantity of the static electricity measured by the surface electrometer becomes small. Reversely, if the measured object is more distant from the ground surface as shown in FIG. 3 (B), only lower electric fields are attracted to the ground surface, and the quantity of the static electricity measured by the surface electrometer therefore becomes large. Therefore, the measured quantity of the static electricity is different depending on the installed position of the measured object.

At manufacturing sites such as factories, the situation of abutment of a probe of the surface electrometer is varied depending on the structures/shapes of manufacturing lines, the sizes and shapes of measured objects, etc. Variation in the calculated quantity of static electricity depending on the situation of abutment of the probe in this manner is not preferred.

(Overall Outline)

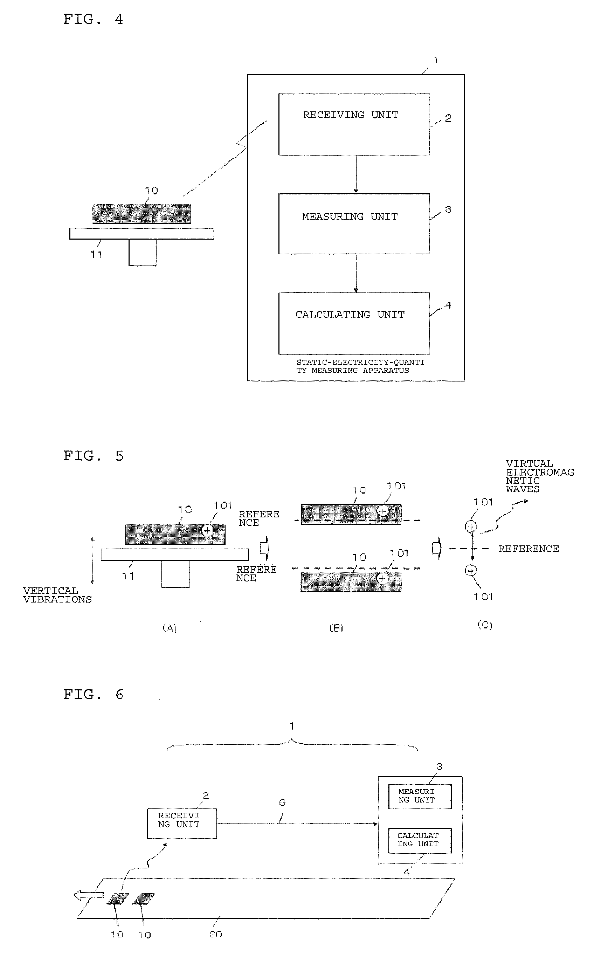

Next, overall outlines of a static-electricity-quantity measuring apparatus of the first embodiment of the present invention will be explained. FIG. 4 is a block diagram of the static-electricity-quantity measuring apparatus of the first embodiment of the present invention.

The static-electricity-quantity measuring apparatus 1 is provided with a receiving unit 2, a measuring unit 3, and a calculating unit 4. The receiving unit 2 receives virtual electromagnetic waves generated by the vibrations applied to a measured object 10. The measuring unit 3 measures at least one of the intensity(ies), frequency(ies), and phase(s) of the virtual electromagnetic waves. The calculating unit 4 calculates the quantity of the static electricity of the measured object 10 based on the results of measurement of the measuring unit 3 (more specifically, based on at least one of the measured intensity, frequency, and phase of the virtual electromagnetic waves). The static-electricity-quantity measuring apparatus 1 can measure the quantity of static electricity of the measured object 10 since the apparatus is provided with the receiving unit 2, the measuring unit 3, and the calculating unit 4.

The first data used by the static-electricity-quantity measuring apparatus 1 for measuring the quantity of static electricity is the virtual electromagnetic waves received by the receiving unit 2. The virtual electromagnetic waves are generated by the vibrations applied to the measured object 10. FIG. 5 is an explanatory drawing showing generation of the virtual electromagnetic waves of the measured object in the first embodiment of the present invention.

The measured object 10 is installed on a mount 11. In a factory, the mount 11 may be a manufacturing line on which an electronic part or a chemical product serving as the measured object 10 flows. The measured object 10 is flowing on the manufacturing line, and the static-electricity-quantity measuring apparatus 1 measures the quantity of the static electricity of the measured object 10 flowing on the manufacturing line.

FIG. 5 gives explanations in the order of (A), (B), and (C) from the left. First, as shown in FIG. 3 (A), the mount 11 is vertically vibrated. The mount 11 is vertically vibrated, for example, since a vibration generating mechanism is built in the mount 11, a vibration generator is installed on a bottom surface of the mount 11, or sound waves are radiated. In this case, the measured object 10 installed on the mount 11 is electrified with static electricity for some reason and has charge 101.

The measured object 10 is also moved vertically by the vertical vibrations. Along with the vertical movement of the measured object 10, the charge 101 is also moved vertically. The vertical movement of the charge 101 is as shown in FIG. 5 (B). When a certain plane is considered as a reference (shown by a broken line in FIG. 5) in the vertical movement of the charge 101, the charge 101 repeats a state in which the charge is positioned above the reference (positive region) and a state in which the charge is positioned below the reference (negative region). The back-and-forth movement of the charge 101 between the positive and negative of the reference can be considered as a virtual alternating current caused by the charge 101 as shown in FIG. 5 (C).

The waves of the electric fields generated by the virtual alternating current are the virtual electromagnetic waves (or electromagnetic fields) received by the receiving unit 2.

The virtual electromagnetic waves have the same frequency as the number of the vibrations of the vertical movement applied to the mount 11 (the measured object 10 as a result).

The receiving unit 2 can receive the virtual electromagnetic waves even if there is a variation(s) such as differences in the angles, distances, and areas between the receiving unit 2 and the measured object 10.

In this manner, the virtual electromagnetic waves generated when vibrations are applied to the measured object 10 are received by the receiving unit 2, and the final quantity of static electricity is calculated. As a result, the static-electricity-quantity measuring apparatus 1 does not easily cause variations or errors of measurement results caused by, for example, probing, which is difficult depending on facilities and measured objects. The receiving unit 2 receives the virtual electromagnetic waves generated by the mechanism explained by FIG. 5. The virtual electromagnetic waves have an intensity, frequency, and phase. The receiving unit 2 outputs the received virtual electromagnetic waves to the measuring unit 3. The measuring unit 3 measures at least one of the intensity, frequency, and phase of the virtual electromagnetic waves. The measuring unit 3 outputs the result of this measurement to the calculating unit 4. The calculating unit 4 can calculate, for example, the electric potential of the charge 101 from the intensity of the virtual electromagnetic waves. The electric potential of the charge 101 represents the quantity of the static electricity, which has been electrifying the measured object 10.

From the correspondence relation between the intensity of virtual electromagnetic waves and the quantity of static electricity, the calculating unit 4 calculates the quantity of the static electricity of the measured object 10. The quantity of the static electricity has an extremely accurate value since the reception of the virtual electromagnetic waves by the receiving unit 2 does not depend on the environment of the measurement. As a matter of course, since the mechanism which generates the virtual electromagnetic waves and the mechanism of the receiving unit 2, which receives the virtual electromagnetic waves, are simple, the static-electricity-quantity measuring apparatus 1 can be easily incorporated in a manufacturing site such as a factory. Therefore, the static-electricity-quantity measuring apparatus 1 can continuously measure the quantities of the static electricity of many electronic parts or chemical products flowing on a manufacturing line.

The static-electricity-quantity measuring apparatus 1 of the first embodiment can precisely measure the quantities of the static electricity of a massive amount of electronic parts, chemical products, etc. even in a manufacturing line of, for example, a factory by using the virtual electromagnetic waves generated by the vibrations.

Next, details of each part will be explained.

(Measured Objects)

The measured objects 10 are objects desired to be subjected to measurement of the quantity of static electricity. The objects are various parts or products which flow on factory lines, etc.

For example, in manufacturing sites of the field of semiconductors or liquid crystals, the measured objects 10 are the things which flow on manufacturing lines such as parts packages, electronic parts, semiconductor integrated parts, semiconductor wafers, and liquid-crystal glass materials or working bodies such as apparatuses, packaging materials, and workers. In manufacturing sites of electric/electronic fields, the measured objects 10 are electronic parts, electronic elements, electronic boards, or electronic devices or are apparatuses or packaging materials.

In manufacturing sites of the field of chemical products, the measured objects 10 are chemical products, fiber products, film products, etc. In manufacturing sites of the field of foods or drugs, the measured objects 10 are foods, drugs, insulating materials, apparatuses, etc. In manufacturing sites of the field of resins or films, the measured objects 10 are resin products, resin members, film products, film members, etc. and also include insulating materials, etc. Similarly, in the field of machines or transportation equipment, the measured objects 10 include machine parts, equipment for transportation, electrically conductive materials, packages, etc. In manufacturing sites of the field of paper or fiber products, the measured objects 10 include paper or fiber products. In manufacturing sites of the field of metals, the measured objects 10 include metal products, metal materials, etc.

These measured objects 10 in these fields are subjected to measurement since all of the objects cause manufacturing troubles or product troubles if the electrified quantity of static electricity thereof is large. As a matter of course, workers, equipment for working, etc. may be options of the measured objects 10. The measured objects 10 may be subjected to application of vibrations and measurement of the quantity of static electricity while they are flowing on manufacturing lines or may be subjected to measurement at a special location such as a measurement area.

(Receiving Unit)

The receiving unit 2 receives virtual electromagnetic waves. Since the virtual electromagnetic waves are the waves of electric fields, the virtual electromagnetic waves can be received when the receiving unit 2 is provided with an antenna. The virtual electromagnetic waves have a frequency equivalent to the number of the vertical vibrations of the measured object 10. For example, if the vertical vibrations of the measured object 10 is 100 Hz, the frequency of the virtual electromagnetic waves is also 100 Hz. The receiving unit 2 can receive the virtual electromagnetic waves when the receiving unit 2 is provided with the antenna capable of receiving 100 Hz. When an amplifier, a filter, etc. are provided in accordance with needs with respect to the received virtual electromagnetic waves, a gain necessary for detecting the intensity of the virtual electromagnetic waves can be obtained.

The receiving unit 2 outputs the information (data obtained by converting the virtual electromagnetic waves to electric signals, data which has further undergone various processing, data serving as waveforms, etc.) of the received virtual electromagnetic waves to the measuring unit 3. Since the measuring unit 3 and the calculating unit 4 are only required to execute processes based on the virtual electromagnetic waves output from the receiving unit 2, the measuring unit 3 and the calculating unit 4 may be installed at a position distant from the receiving unit 2. On the other hand, the receiving unit 2 is required to receive the virtual electromagnetic waves, which are emitted from the measured object 10; therefore, the receiving unit 2 has to be positioned near the measured object 10.

The receiving unit 2 and the measuring unit 3 are only required to be connected so that data can be transmitted therebetween by wire or wirelessly. Therefore, the static-electricity-quantity measuring apparatus 1 may be installed so as to be separated into the receiving unit 2 and the other part as shown in FIG. 6. FIG. 6 is a schematic drawing showing an installation state of the static-electricity-quantity measuring apparatus 1 of the first embodiment of the present invention.

The static-electricity-quantity measuring apparatus 1 shown in FIG. 6 is installed at a manufacturing site such as a factory. The measured objects 10 such as electronic parts, chemical products, and/or machine parts are sequentially flowing on a manufacturing line 20. At any of locations of the manufacturing line 20, the receiving unit 2 has to receive the virtual electromagnetic waves emitted from the measured objects 10. Therefore, the receiving unit 2 is installed, for example, at a distal end of the manufacturing line 20 and receives the virtual electromagnetic waves. Even if the receiving unit 2 is fixedly installed at the distal end of the manufacturing line 20, the receiving unit 2 can sequentially receive the virtual electromagnetic waves of the measured objects 10 since the measured objects 10 sequentially flow on the manufacturing line 20.

On the other hand, since the measuring unit 3 and the calculating unit 4 calculate the quantity of the static electricity of each of the plurality of measured objects 10, the measuring unit 3 and the calculating unit 4 can carry out the calculation even at a position distant from the generation sites of the virtual electromagnetic waves. Particularly, the measuring unit 3 and the calculating unit 4 are mounted in a dedicated computing apparatus or a general-purpose computer in many cases; therefore, the measuring unit 3 and the calculating unit 4 are more usable when installed at positions distant from the generation sites of the virtual electromagnetic waves (in other words, the positions adjacent to the manufacturing line 20). Therefore, as shown in FIG. 6, the measuring unit 3 and the calculating unit 4 are installed at the positions distant from the generation sites of the virtual electromagnetic waves.

In a case of such a situation, the receiving unit 2 and the measuring unit 3 are connected by a wired or a wireless network, and the receiving unit 2 outputs the data of the received virtual electromagnetic waves.

In this manner, the receiving unit 2 is preferred to be installed at a location close to the generation sites of the virtual electromagnetic waves. As shown in FIG. 6, the receiving unit 2 may be fixed at a certain location while the measured objects 10 move, or the receiving unit 2 may move with respect to the measured objects 10 so as to execute reception of the virtual electromagnetic waves with respect to each of the plurality of measured objects 10.

(Measuring Unit)

The measuring unit 3 measures at least one of the intensity, frequency, and phase of the virtual electromagnetic waves output by the receiving unit 2. The virtual electromagnetic waves have elements of the intensity, frequency, and phase. Each of the elements represents the electric potential of the charge 101 (the charge 101 is charge generated by electrification of static electricity), which is the source of the virtual electromagnetic waves, and represents the sign (positive or negative) thereof.

Therefore, the static-electricity-quantity measuring apparatus 1 can measure the quantity of static electricity by focusing on at least one of these elements.

The measuring unit 3 subjects the received virtual electromagnetic waves to data processing, thereby measuring the intensity thereof. The frequency and phase can be also measured by carrying out time-frequency transformation in accordance with needs. Publicly known techniques can be used for the measurement of the intensity, frequency, and phase by the measuring unit 3, and detailed explanations thereof will be omitted here. General signal processing can be used.

The measuring unit 3 may measure all of the intensity, frequency, and phase or may measure one of them in accordance with needs. As a matter of course, a plurality of the elements may be measured. The measuring unit 3 outputs measured results thereof to the calculating unit 4. Therefore, the measuring unit 3 and the calculating unit 4 are electrically connected to each other. The electrical connection may be realized by wired or wireless network connection.

(Calculating Unit)

The calculating unit 4 calculates the quantity of the static electricity of the measured object 10 based on at least one of the intensity, frequency, and phase of the virtual electromagnetic waves, which are measurement results output from the measuring unit 3. In this process, the calculating unit 4 may calculate the quantity of the static electricity based on only one of the intensity, frequency, and phase or may calculate the quantity of the static electricity based on a combination of a plurality of elements of the intensity, frequency, and phase.

In any case, the intensity, frequency, and phase of the virtual electromagnetic waves are indexes representing a state of generated static electricity, and the calculating unit 4 can estimate the electric potential of the static electricity or the sign thereof based on these elements.

(Calculation based on Correspondence Relational Expression)

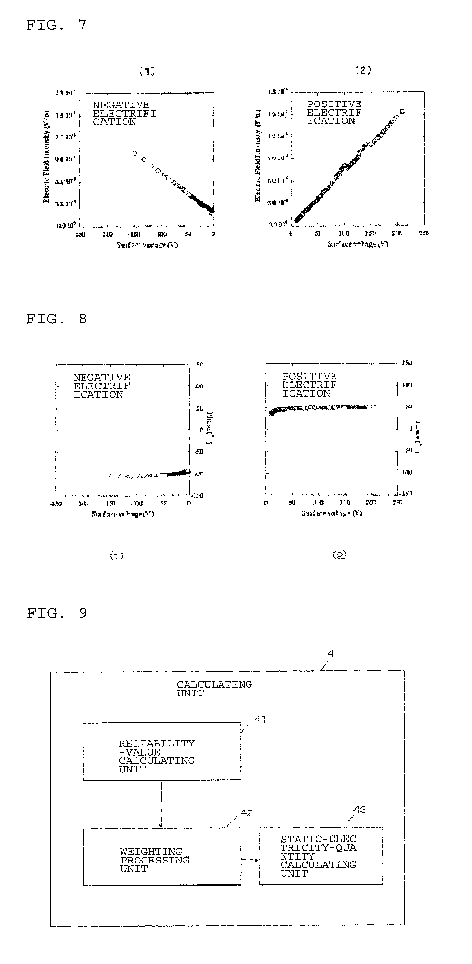

The calculating unit 4 can also calculate the quantity of the static electricity of the measured object 10 based on a correspondence relational expression of the intensity of the virtual electromagnetic waves and the quantity of static electricity. The intensity has a predetermined correspondence relation with the quantity of charge of the charge 101 electrifying the measured object 10 (in other words, the quantity of the static electricity owned by the measured object 10). FIG. 7 shows graphs showing relations of the measured intensities of the electromagnetic waves and surface potentials of the measured objects 10 in the first embodiment of the present invention. Herein, the surface potentials can be considered as the quantities of static electricity. FIG. 7 (1) shows a case in which the measured object 10 has been negatively electrified, and FIG. 7 (2) shows a case in which the measured object 10 is positively electrified. In both of FIG. 7 (1) and (2), if the quantity of the static electricity of the measured object 10 is high, the intensity of electromagnetic waves is also high; and, if the quantity of the static electricity of the measured object 10 is low, the intensity of the electromagnetic waves is also low. The intensity of the electromagnetic waves and the quantity of static electricity are in a linear relation. Therefore, if the vibrations, measured distance, and frequency of the measured object 10 are constant, the correspondence relation thereof can be expressed by a proportional relational expression shown below.

$$V = A \times I$$

(V: the quantity of static electricity, A: constant, I: the intensity of electromagnetic waves)

The calculating unit 4 substitutes the obtained intensity of the virtual electromagnetic waves into this correspondence relational expression. As a result of this substitution, computing of the correspondence relational expression is carried out, and the calculating unit 4 can calculate the quantity of static electricity as a result. In a case in which the calculating unit 4 uses this correspondence relational expression, if the correspondence relational expression is appropriately changed in accordance with experimental rules, a more precise static electricity quantity can be calculated.

(Calculation using Relational Table)

The calculating unit 4 may calculate the quantity of static electricity based on a relational table showing the correspondence relation between the intensity of the virtual electromagnetic waves and the quantity of static electricity. Different from the correspondence relational expression, this calculation is based on discrete values, but has an advantage that processing load is small. The relational table can be empirically changed or updated, and the calculating unit 4 can carry out more precise calculation of the quantity of static electricity along with accumulation of usage.

As well as the correspondence relational expression, the relational table can be stored in a memory provided in the calculating unit 4. The memory may be provided in the calculating unit 4 or may be a memory shared by the calculating unit 4 and other elements.

The calculating unit 4 can calculate the quantity of static electricity based on at least one of the correspondence relational expression and the relational table, and which one to be used can be appropriately selected depending on characteristics of the measured object 10 or characteristics of a measured site. Depending on a case, the calculating unit 4 may calculate the quantity of static electricity by using both of the correspondence relational expression and the relational table.

The correspondence relational expression and the relational table herein show the relations between the intensity of the virtual electromagnetic waves and the quantity of static electricity, but may show the relations between the frequency of the virtual electromagnetic waves and the quantity of static electricity.

It is also preferred to calculate the quantity of static electricity after correcting the element that is dependent on the frequency by substituting the intensity into the correspondence relational expression or the relational table after carrying out correction by the frequency by the calculating unit 4.

It has been explained that, based on the intensity of the virtual electromagnetic waves, the calculating unit 4 calculates the quantity of static electricity based on at least one of the correspondence relational expression and the relational table. However, based on the frequency of the virtual electromagnetic waves, the quantity of static electricity may be calculated based on at least one of the correspondence relational expression and the relational table.

The calculating unit 4 may carry out correction based on the frequency and calculate the quantity of static electricity.

(Positive/Negative Calculation by Phase)

From the phase of the virtual electromagnetic waves, the calculating unit 4 can calculate whether the static electricity possessed by the measured object is positive/negative. The virtual electromagnetic waves have phases as a matter of course, and the phase represent positive/negative of the static electricity. When positive/negative of the static electricity is determined, there is an advantage that a means for removing the static electricity of the measured object 10 is found out. For example, if the measured object 10 is electrified with static electricity of positive electric potential, the static electricity of the measured obj ect 10 can be removed by spraying, for example, ions having negative charge. Reversely, if the measured object 10 is electrified with static electricity of negative electric potential, the static electricity of the measured object 10 can be removed by spraying, for example, ions having positive charge.

FIG. 8 shows graphs showing phases measured in the first embodiment of the present invention.

FIG. 8 (1) is showing the phases of virtual electromagnetic waves from a certain measured object 10, and the phases are included in a negative range. In other words, the measured object 10 has static electricity of negative electric potential.

On the other hand, FIG. 8 (2) is showing phases of the virtual electromagnetic waves from a certain measured object 10, and the phases are included in a positive range. In other words, it can be understood that the measured object 10 has static electricity of positive electric potential.

In this manner, based on the phase of the virtual electromagnetic waves, the calculating unit 4 can determine positive/negative of the static electricity possessed by the measured object 10. The calculating unit 4 outputs the thus-calculated quantity of the static electricity and the positive/negative of the static electricity to a displaying unit provided in the static-electricity-quantity measuring apparatus 1 and notifies a user of the results.

In the above described manner, based on the virtual electromagnetic waves generated by the vibrations of the measured object 10, the static-electricity-quantity measuring apparatus 1 of the first embodiment can measure the quantity of the static electricity thereof. The quantity of static electricity can be measured as long as the virtual electromagnetic waves can be received; therefore, even at a factory or a manufacturing site where it is difficult to be close to the measured object 10, the static-electricity-quantity measuring apparatus 1 can easily carry out measurement. Therefore, the quantities of static electricity can be easily and reliably measured for objects which need measurement of the quantities of static electricity such as electronic parts, machine parts, foods, and chemical products without the limitations by the structures and characteristics of factories and manufacturing sites. As a result, failure of parts and products at factories and manufacturing sites and troubles of finished products, etc. after shipping can be prevented in advance, and the yield of manufacturing can be increased.

When the yield is increased, manufacturing cost is reduced as a matter of course, and manufacturing sites in Japan can be prevented from being moved to overseas.

(Second Embodiment)

Next, a second embodiment will be explained. In the second embodiment, improvement of calculation accuracy of the static electricity quantity by the calculating unit 4 will be explained.

As explained in the first embodiment, the calculating unit 4 measures the quantity of the static electricity of the measured object 10 based on the intensity of the virtual electromagnetic waves. In this process, the intensity of the virtual electromagnetic waves are sometimes affected by the positional relation between the receiving unit 2 and the measured object 10 or a surrounding environment. In such a case, the intensity of the virtual electromagnetic waves measured by the measuring unit 3 may not be accurate.

In order to further eliminate environment dependency of reception of such virtual electromagnetic waves, the calculating unit 4 can further improve the calculation accuracy of the quantity of static electricity by using a reliability value based on the amplitude of the measured object. FIG. 9 is an internal block diagram of the calculating unit of the second embodiment of the present invention. FIG. 9 shows a configuration of a case in which the calculating unit 4 improves the calculation accuracy of the quantity of static electricity by using the reliability value.

The calculating unit 4 is provided with a reliability-value calculating unit 41, a weighting processing unit 42, and a static-electricity-quantity calculating unit 43. The reliability-value calculating unit 41 calculates the reliability value based on the amplitude of the measured object. If the amplitude is large, it is considered that the virtual electromagnetic waves which have reached the receiving unit 2 have not been affected much by a surrounding environment. On the other hand, if the amplitude is small, it is considered that the virtual electromagnetic waves which have reached the receiving unit 2 have been affected by the surrounding environment. If affected by the surrounding environment, there is influence caused by noise, fading, etc.

The reliability-value calculating unit 41 compares the amplitude with a predetermined value and calculates a numerical value which serves as an index of the reliability value. For example, the amplitude is configured to be sortable into four levels and is sorted with a value "0" to a value "3" from a lowest level to a highest level.

The reliability-value calculating unit 41 outputs the calculated reliability value to the weighting processing unit 42. The weighting processing unit 42 multiplies the reliability value by the intensity of the virtual electromagnetic waves to carry out weighting. More specifically, if the reliability value is large (for example, a value "3"), the intensity of the virtual electromagnetic waves after the weighting becomes large. On the other hand, if the reliability value is small (for example, a value "1"), the intensity of the virtual electromagnetic waves becomes small. The magnitude of the intensity of the virtual electromagnetic waves is corrected in accordance with the reliability value.

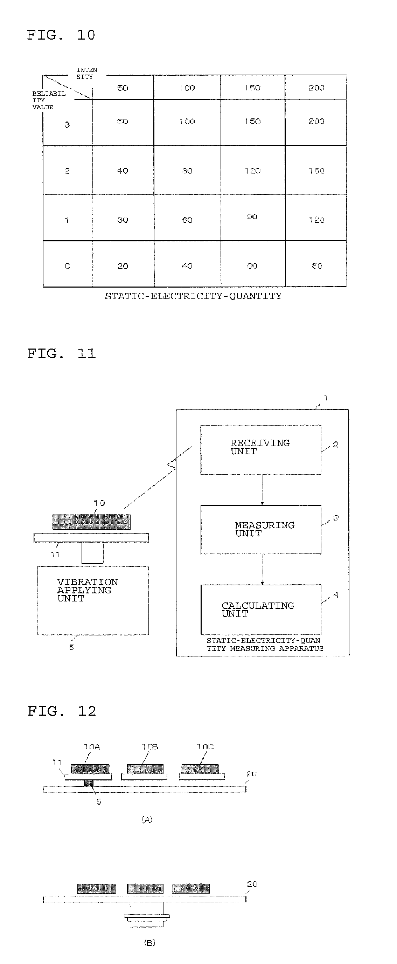

The static-electricity-quantity calculating unit 43 calculates the quantity of static electricity based on the intensity after this weighting. FIG. 10 is a table showing relations between the weighting and the calculated quantity of static electricity in the second embodiment of the present invention. The calculating unit 4 uses this table to calculate the quantity of static electricity matching the surrounding environment by the weighting in accordance with the reliability value.

The vertical axis of the table shows the reliability values, wherein the values "3", "2", "1", and "0" are shown from higher reliability. If the calculating unit 4 is comprised of a semiconductor integrated circuit and software, the reliability values are expressed by 2-bit signals. The horizontal axis of the table shows the intensities of the virtual electromagnetic waves measured by the measuring unit 3 before weighting, wherein a unit system is not particularly taken into consideration. The weighting processing unit 42 subjects the intensities to weighting according to the reliability values. Based on the weighted intensity, the static-electricity-quantity calculating unit 43 calculates the quantity of static electricity. The values described in the tables are the quantities of the static electricity calculated by the static-electricity-quantity calculating unit 43. The unit system is not taken into consideration.

As is shown in this table, when the reliability value based on the amplitude of the measured object is used in weighting of a static-electricity-quantity calculation in a case of a low reliability value, the quantity of the static electricity is calculated to be small (or large). Thus, the quantity of static electricity which has taken into the surrounding environment into consideration is calculated by the calculating unit 4.

The reliability-value calculating unit 41 calculates the reliability value based on the amplitude of the measured object, but may calculate the reliability value based on another element(s). The average value, dispersion, etc. of the amplitude can be used. The table shown in FIG. 10 shows the relation that the lower the reliability value, the smaller the quantity of static electricity. However, the calculating unit 4 may calculate the quantity of static electricity based on a relation that, reversely, the lower the reliability value, the larger the quantity of static electricity.

As described above, the static-electricity-quantity measuring apparatus 1 of the second embodiment can measure the quantity of static electricity with high accuracy in consideration of the surrounding environment according to the reliability value based on the element of the virtual electromagnetic waves.

(Third Embodiment)

Next, a third embodiment will be explained. In the third embodiment, various modes of applying vibrations to the measured object 10 will be explained.

FIG. 11 is a block diagram of a static-electricity-quantity measuring apparatus of the third embodiment. The static-electricity-quantity measuring apparatus 1 of FIG. 11 is provided with a vibration applying unit 5, which applies vibrations to the measured object 10. The vibration applying unit exerts a function of applying physical vibrations to the mount 11 to apply vibrations to the measured object 10 or applying vibrations to the measured object 10 by sound waves.

(Individual Application and Entire Application)

The vibration applying unit 5 directly applies vibrations to the measured object 10 in some cases or applies vibrations to the mount 11 in some cases. For example, if the measured object 10 is a part element such as an electronic part, an electric part, a machine part, food, a chemical product, a metal member, or a resin member, the vibration applying unit 5 may carry out individual application of applying vibrations to the part element transported by a manufacturing line. Alternatively, entire application of applying vibrations to the manufacturing line per se on which the part element is placed may be carried out.

In the former case, instead of applying vibrations to the manufacturing line, the vibration applying unit 5 applies vibrations to the mount 11 installed between the manufacturing line and the measured object 10. Alternatively, the vibration applying unit 5 applies vibrations to each of the part elements flowing on the manufacturing line by radiating sound waves. When individual application to each of the part elements is carried out, there is an advantage that the virtual electromagnetic waves from the part element which is not a measured object are not erroneously received.

In the latter case, the vibration applying unit 5 vibrates the manufacturing line per se. In this case, the vibration applying unit 5 may physically vibrate the manufacturing line by using a so-called vibrator or may vibrate the manufacturing line by radiating sound waves.

FIG. 12 is a schematic drawing showing the individual application and the entire application of the third embodiment of the present invention. FIG. 12 (A) shows a state in which the vibration applying unit 5 applies vibrations to each of the plurality of part elements flowing on the manufacturing line. FIG. 12 (B) shows a state in which the vibration applying unit 5 applies vibrations to the manufacturing line per se.

In FIG. 12 (A), the measured objects 10 flow on the manufacturing line 20. In this case, at a certain moment, measured objects 10A, 10B, and 10C are flowing on the manufacturing line 20. The measured objects 10A, 10B, and 10C are placed on the mounts 11, respectively. The vibration applying unit 5 applies vibrations only to the mount 11 of the measured object 10A. As a result, only the measured object 10A generates virtual electromagnetic waves. The receiving unit 2 receives the virtual electromagnetic waves of the measured object 10A, and the static-electricity-quantity measuring apparatus 1 measures the quantity of the static electricity of the measured object 10A. The vibration applying unit 5 is not limited to apply physical vibrations, but may radiate sound waves.

In FIG. 12 (B), the plurality of measured objects 10 are flowing on the manufacturing line 20. In this case, the vibration applying unit 5 vibrates the manufacturing line 20 per se. For example, the vibration applying unit 5 is installed at a bottom surface of the manufacturing line 20, and the vibration applying unit applies physical vibrations to the bottom surface of the manufacturing line 20. As a result of this act, the entire manufacturing line 20 is vibrated, and the measured objects 10 are vibrated as a result. In this process, the measured obj ect 10 which passes through the region in which the vibration applying unit 5 is installed is vibrated the most; therefore, the receiving unit 2 is preferred to be installed in the vicinity thereof. Alternatively, in the case in which the entire manufacturing line 20 is vibrated, the receiving unit 2 may be configured to be installed at a location convenient for installment and receive virtual electromagnetic waves from the flowing and vibrating measured object 10.

(Physical Vibration Application and Sound Wave Application)

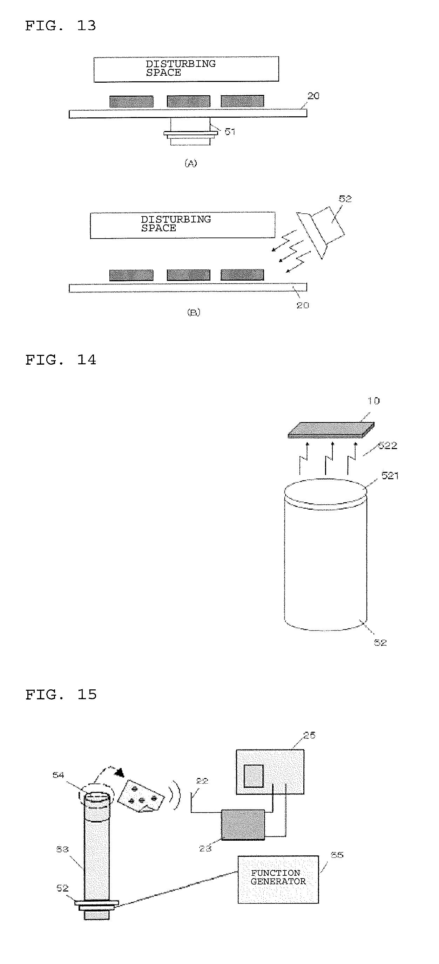

As described above, the vibration applying unit 5 can use the physical vibration application using a vibrating member and the vibration application by sound wave radiation using a speaker or the like. FIG. 13 is a schematic drawing showing a state of vibration application of the third embodiment of the present invention. FI. 13 (A) shows a state in which vibrations are applied to the manufacturing line 20 by a vibrating member 51. As a matter of course, when the vibrations are applied to the manufacturing line 20, the vibrations are applied to the measured objects 10 as a result.

On the other hand, FIG. 13 (B) shows a state in which vibrations are applied to the measured objects 10 by a speaker 52. The speaker 52 can radiate sound waves having a predetermined amplitude or frequency, and the sound waves become air vibrations. The air vibrations vibrate the measured objects 10 as a matter of course.

As shown in FIG. 13 (A), the vibrating member 51 can be installed on the bottom surface of the manufacturing line 20. In a manufacturing site such as a factory, disturbing space such as a cover or another line is present above the manufacturing line 20. Therefore, the disturbing space has to be avoided to apply the vibrations. In conventional techniques, an apparatus which applies vibrations and detects amplitude, etc. from vibrations used to have a large scale; therefore, if there is such disturbing space, it has been impossible to install a vibration applying unit and a measuring apparatus. However, the vibrating member 51 is only required to be installed at the bottom surface of the manufacturing line 20, and the static-electricity-quantity measuring apparatus 1 is only required to be installed in a detectable range of the virtual electromagnetic waves. Therefore, there is no influence of such disturbing space.

Similarly, as shown in FIG. 13 (B), since the speaker 52 can radiate sound waves from a position distant from the manufacturing line 20 or the measured object 10, it is not affected by the disturbing space.

In this manner, the vibration applying unit 5 may carry out direct application (FIG. 13 (A)) of directly applying vibrations to the measured object 10 (this includes the mount 11 and the manufacturing line 20) by using the vibrating member 51 or may carry out indirect application (FIG. 13 (B)) of vibrations by applying sound waves to the measured objects 10 by using the speaker 52. As a matter of course the direct application and the indirect application may be used in combination. In either case, the electrified measured object 10 generates virtual electromagnetic waves. The receiving unit 2 is only required to receive the virtual electromagnetic waves. Therefore, the installed position of the vibration applying unit 5 and the installed position of the receiving unit 2 have a high degree of freedom and are not affected by the disturbing space. Therefore, the static-electricity-quantity measuring apparatus 1 of the present invention can be suitably used at a manufacturing site where installation space has a low degree of freedom due to the structures and characteristics of the apparatus, equipment, etc. As a result, the static-electricity-quantity measuring apparatus 1 can easily and reliably measure the quantities of static electricity of various parts and products at manufacturing sites.

(Measurement of the Quantity of Static Electricity of Part of Product)

In a case in which the measured object 10 is a part element which flows on the manufacturing line 20, as shown in FIGs. 12 and 13, the quantity of static electricity can be measured by receiving virtual electromagnetic waves from the entire vibrating part. Also in a case in which the measured object 10 is a product, the quantity of the static electricity of the entire product can be measured by receiving the virtual electromagnetic waves from the entire vibrating product.

However, in some cases, the quantity of the static electricity of part of a product (for example, in a case of a product on which a plurality of parts are mounted, any of these parts) is desired to be measured. In that case, the vibration applying unit 5 applies vibrations to the entire product, and the receiving unit 2 carries out reception directing with respect to the region of which static electricity quantity in the product is desired to be measured. As a result, the receiving unit 2 can receive the virtual electromagnetic waves from the partial region in the product (in other words, from the part of the measured object), and the static-electricity-quantity measuring apparatus 1 can measure the quantity of the static electricity of the part or region serving as the measured object.

(Vibration Characteristics)

The vibration applying unit 5 applies vibrations to the measured object 10. At this point, the measured object 10 to which the vibrations are applied emit virtual electromagnetic waves corresponding to the vibrations. The virtual electromagnetic waves are received by the receiving unit 2 and used in calculation of the quantity of the static electricity in the static-electricity-quantity measuring apparatus 1. The intensity or the frequency of the virtual electromagnetic waves relate to easiness of the processes in the receiving unit 2 or the measuring unit 3.

The intensity and the frequency of the virtual electromagnetic waves correspond to the amplitude of the vibrations applied to the measured object 10 and the number of vibrations. Therefore, it is preferred that the amplitude of the vibrations applied by the vibration applying unit 5 and the number of the vibrations be determined based on specifications of at least one of the receiving unit 2 and the measuring unit 3. This is for a reason that the receiving unit 2 and the measuring unit 3 often have an amplitude or frequency of the measured object which can be easily received or easily measured.

Therefore, it is preferred that the static-electricity-quantity measuring apparatus 1 use the vibration applying unit 5 corresponding to the characteristics of the receiving unit 2 and the measuring unit 3.

(Sound Wave Application)

As described above, the vibration applying unit 5 can generate vibrations at the measured object 10 by radiating sound waves by using the speaker 52.

The speaker 52 is one of sound-wave generating units which generate sound waves. The speaker 52 has a vibrating plate, which radiates sound waves. The vibrating plate is vibrated by electric signals or mechanical vibrations. FIG. 14 is an explanatory drawing of sound wave radiation by the speaker in the third embodiment of the present invention.

The speaker 52, which one of the sound generating units, is provided with a vibrating plate 521. When the vibrating plate 521 is vibrated, sound waves 522 are generated, and the sound waves 522 are radiated to the measured object 10. At this point, it is preferred that the vibrating plate 521 and the measured object 10 be directly or indirectly opposed to each other. In FIG. 14, the vibrating plate 521 and the measured object 10 are directly opposed to each other. It is not limited to such direct opposition, but they may be indirectly opposed with a member interposed between the vibrating plate 521 and the measured object 10. This is for a reason that, when the vibrating plate 521 is directly or indirectly opposed to the measured object 10, the generated sound waves 522 can be easily radiated to the measured object 10. When the sound waves are easily radiated, the measured object 10 is reliably vibrated and emits virtual electromagnetic waves. Particularly, when they are opposed to each other, reception adjustment at the receiving unit 2 becomes easy since the measured object 10 is vibrated at a frequency similar to the frequency of the sound waves 522.

As a matter of course, it is not limited to complete opposition, but opposition in a state with somewhat twist or angle may be also employed.

It is also preferred that the speaker 52 have a focusing function of focusing the sound waves in accordance with the size of the measured object 10. When the sound waves can be focused, even if the measured object 10 is small, vibrations which cause the measured object 10 such as a small part to generate virtual electromagnetic waves since the focusing function focuses the sound waves and radiate the sound waves to the measured object 10.

29      **EP 2 696 207 A1**      30

The vibration applying unit 5 has a vibrator, and the vibrator may be installed at an end of the measured object 10. When the vibrator is installed at the end of the measured obj ect 10, the measured object 10 is vibrated by the vibrations from the vibrator. When the vibrator is installed at the end of the measured object 10, the measured object 10 reliably generates vibrations. The vibrations cause generation of virtual electromagnetic waves. Therefore, the static-electricity-quantity measuring apparatus 1 can reliably measure the quantity of static electricity.

(Specific Example)

Next, a specific example will be explained.

FIG. 15 is a schematic drawing showing a state of vibration application in the third embodiment of the present invention. The speaker 52 generates sound waves, an acrylic tube 53 having a diameter of 60 mm, a height of 1 mm, and a thickness of 5 mm is installed on a vibrating surface of the speaker 52, and a polyimide film 54 serving as a measured obj ect is attached to an upper-surface opening thereof. Furthermore, the speaker 52 attached to a lower-surface opening is driven via a function generator 55 to radiate sound waves of a frequency of 2 to 10 Hz. The time dependency of the intensity of the virtual electromagnetic waves was measured by an oscilloscope 25 via a monopole antenna 22 and a pre-amplifier 23. In this example, the acrylic tube 53 is used in order to prevent the sound pressure of the speaker 52 from being spread, and the sound waves of 2 to 10 Hz generated from the speaker 52 are radiated to the interior of the acrylic tube 53 and vibrate the polyimide film 54 at the amplitude of about 1 to 3 mm.

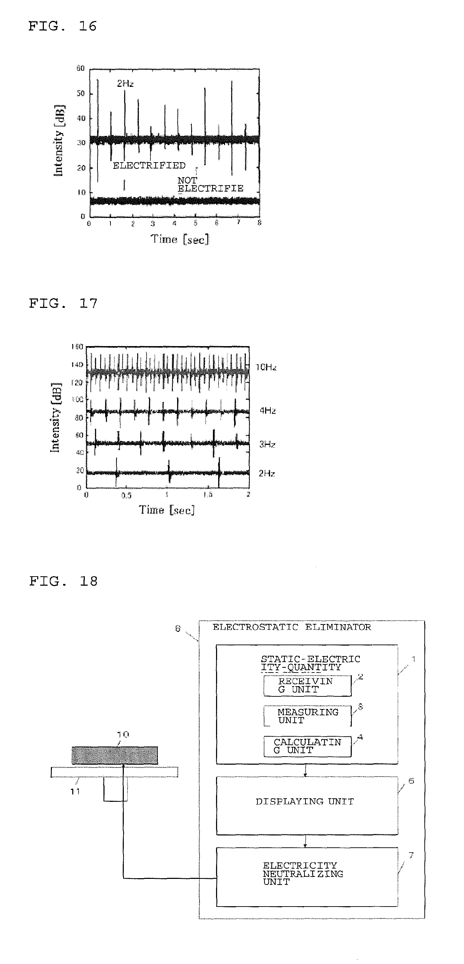

FIG. 16 shows measurement results of the polyimide film 54 which is not electrified and the polyimide film 54 which is electrified in a case in which sound waves of 2 Hz are radiated into the acrylic tube in the configuration of FIG. 15. FIG. 16 is a graph showing the measurement results of the example of the third embodiment of the present invention.

As is clear from FIG. 16, in the case without electrification, the intensity of the virtual electromagnetic waves is not changed regardless of the radiation of the sound waves of 2 Hz. In the case with electrification, in synchronization with the frequency of the sound waves, large changes of about $\pm 20$ dB were observed in the intensity of the virtual electromagnetic waves. Thus, it was proved that the quantity of the static electricity of the measured object appears in the intensity of the virtual electromagnetic waves when the vibration caused by the sound waves are applied to the measured object.

FIG. 17 is a graph showing measurement results of the example of the third embodiment of the present invention. FIG. 17 shows a case in which the number of the vibrations of the sound waves from the speaker 52 is sequentially changed from 2 Hz to 10 Hz. FIG. 17 shows that the intensity of virtual electromagnetic waves are changed to follow the number of the vibrations of the sound waves of the speaker 52. It has been found out that the characteristics of the generated virtual electromagnetic waves are different depending on the specifications of the vibration applying unit, and the specifications of the static-electricity-quantity measuring apparatus 1 should be determined in consideration of this point.

Although it depends on the performance of the monopole antenna 22, etc., in a case in which the measured object is a polyimide film, if the number of vibrations of the sound wave radiation by the speaker 52 is several tens of Hz, the intensity of the virtual electromagnetic waves can be sufficiently detected. In other words, the quantity of the static electricity can be detected. The intensity of the virtual electromagnetic waves and the quantity of static electricity are in a proportional relation, and the static-electricity-quantity measuring apparatus 1 can measure the quantity of the static electricity of the measured object by the intensity of the virtual electromagnetic waves.

Since the amplitude of the measured object is large, the detection sensitivity of the virtual electromagnetic waves is increased. For example, in a case in which the quantity of the static electricity of an entire measured object is measured by vibrating the entire measured object like the polyimide film, it is effective to use the sound waves of a frequency of several Hz to several kHz by which amplitude of 1 $\mu$m or more can be easily obtained. Depending on a measured object, the speaker 52 may be disposed above the measured object, and sound waves from the speaker 52 may be directly radiated to the measured object.

Reversely, if the measured object is a hard material or the periphery thereof is fixed, even when sound waves are partially radiated to the measured object, sufficient virtual electromagnetic waves are not obtained. In this case, it is appropriate to, for example, directly vibrate the mount on which the measured object is placed.

As described above, the relation between the amplitude of the measured object and the number of the vibrations of the radiated sound waves is changed depending on the characteristics of the measured object. Therefore, upon actual measurement of the quantity of static electricity, it is preferred to optimally adjust the values thereof.

In the above described manner, the vibration applying unit using the speaker 52 can generate the virtual electromagnetic waves which facilitate detection of the quantity of static electricity.

(Fourth Embodiment)

Next, a fourth embodiment will be explained. In the fourth embodiment, an electrostatic eliminator will be explained.

The electrostatic eliminator removes the static electricity of the measured object 10 measured by any

16

of the static-electricity-quantity measuring apparatuses 1 explained in the first to third embodiment. FIG. 18 is a block diagram of the electrostatic eliminator of the fourth embodiment of the present invention. As shown in FIG. 18, the electrostatic eliminator 8 is provided with: any of the static-electricity-quantity measuring apparatuses 1 explained in the first to third embodiments; a displaying unit 6, which displays the measured quantity of static electricity; and an electricity neutralizing unit 7, which removes electrifying static electricity.

The displaying unit 6 has a displaying function such as a liquid crystal screen, a computer screen, or a LED screen and displays the measured quantity of static electricity to the user. Depending on the case, the quantity may be notified by sound. By the display of the displaying unit 6, the user can check the quantity of the static electricity of the object.

The electricity neutralizing unit 7 removes the static electricity of the measured object 10 by using a publicly known function such as grounding, etc. Particularly, the characteristics of removal can be changed depending on the positive/negative and magnitude of the quantity of the static electricity; therefore, the static electricity can be reliably removed. In this process, the static electricity of the measured object 10 is directly or indirectly removed.

As described above, the electrostatic eliminator 8 of the fourth embodiment can remove the static electricity of the measured object 10 in accordance with the measured quantity of the static electricity and/or the characteristics thereof.

(Fifth Embodiment)

The static-electricity-quantity measuring apparatus 1 explained in the first to third embodiments may be realized by hardware such as an electronic circuit, a semiconductor integrated circuit, and/or an electronic board or may be realized by software. Also, the apparatus may be realized by combination of hardware and software. In a case in which the apparatus is realized by hardware, the apparatus may be realized by a dedicated computing apparatus or a general-purpose computer. In a case in which the apparatus is realized by a dedicated computing apparatus, the receiving unit 2 is provided with a high-frequency member such as an antenna, and the measuring unit 3 and the calculating unit 4 are realized by an electronic circuit(s) and/or a semiconductor circuit(s). If the apparatus is realized by a computer, a central processing unit realizes the functions of the measuring unit 3 and the calculating unit 4. In this case, the central processing unit realizes these functions by reading and executing a program (s) which realize the functions of the measuring unit 3 and the calculating unit 4.

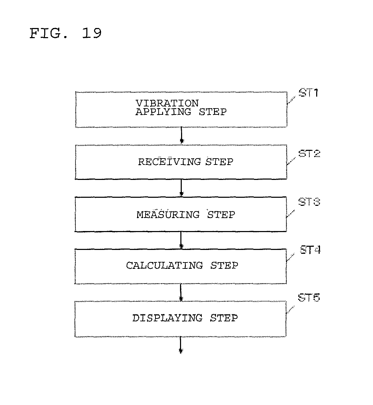

The static-electricity-quantity measuring apparatuses 1 explained in the first to third embodiments can be considered as static-electricity-quantity measuring methods by a computer program or a dedicated apparatus. FIG. 19 is a flow chart showing a static-electricity-quantity measuring method according to a fifth embodiment of the present invention.

In the static-electricity-quantity measuring method, first, in a vibration applying step of step ST1, vibrations are applied to the measured object 10. Application of the vibrations is as explained in the second and third embodiments. Then, in a receiving step of ST2, virtual electromagnetic waves generated by the vibrations applied to the measured object 10 are received. Then, in a measuring step of step ST3, at least one of the intensity, frequency, and phase of the virtual electromagnetic waves is measured. Furthermore, in a calculating step of step ST4, based on the measurement result in the measuring step, the quantity of the static electricity of the measured object 10 is calculated. Finally, the calculated quantity of the static electricity is displayed in a displaying step of step ST5.

In the static-electricity-quantity measuring method, the quantity of static electricity can be calculated by these steps. Not all of step ST1 to step ST5 are essential constituent factors, and any/some of the steps may be used in a different method. All or part of these steps may be provided as a program(s) operable on a computer.

Thus, the static-electricity-quantity measuring apparatuses explained in the first to fifth embodiments are examples explaining the gist of the present invention and include modifications and conversions within a range not departing from the gist of the present invention. Reference Signs List

| | |
|---|---|
| 1 | STATIC-ELECTRICITY-QUANTITY MEASURING APPARATUS |
| 2 | RECEIVING UNIT |
| 3 | MEASURING UNIT |
| 4 | CALCULATING UNIT |
| 5 | VIBRATION APPLYING UNIT |
| 51 | VIBRATING MEMBER |
| 52 | SPEAKER |
| 10 | MEASURED OBJECT |
| 11 | MOUNT |
| 20 | MANUFACTURING LINE |
| 101 | CHARGE |

**Claims**

**1.** A static-electricity-quantity measuring apparatus comprising:

a receiving unit oprable to receive a virtual electromagnetic wave generated by a vibration applied to a measured object;
a measuring unit operable to measure at least one of an intensity, frequency, and phase of the virtual electromagnetic wave received by said receiving unit; and

a calculating unit operable to calculate the quantity of static electricity of the measured object based on a measurement result of said measuring unit.

2.  The static-electricity-quantity measuring apparatus according to claim 1, wherein

the measured object is a product element of any of an electronic part, an electronic element, a semiconductor integrated element, an electronic board, an electronic device, a machine part, a transporting device, a chemical product, food, a paper product, a film product, a metal product, a drug, and a fiber product used at a manufacturing site.

3.  The static-electricity-quantity measuring apparatus according to claim 2, wherein

the product element flows on a manufacturing line of the manufacturing site.

4.  The static-electricity-quantity measuring apparatus according to any of claims 1 to 3, wherein

said calculating unit calculates the quantity of the static electricity of the measured object based on at least one of

a correspondence relational expression of the intensity of the virtual electromagnetic wave and the quantity of static electricity and

a relational table of the intensity of the virtual electromagnetic wave and the quantity of static electricity.

5.  The static-electricity-quantity measuring apparatus according to claim 4, wherein

said calculating unit calculates a reliability value based on amplitude of the measured object and subjects the quantity of the static electricity calculated based on the intensity of the virtual electromagnetic wave to weighting of the reliability value to calculate the quantity of the static electricity of the measured object.

6.  The static-electricity-quantity measuring apparatus according to claim 5, wherein

the reliability value is small if the amplitude of the measured object is small and is large if the amplitude of the measured object is large.

7.  The static-electricity-quantity measuring apparatus according to any of claims 1 to 6, wherein

said calculating unit determines positive/negative of the static electricity electrifying the measured object based on the phase of the virtual electromagnetic wave.

8.  The static-electricity-quantity measuring apparatus according to any of claims 1 to 7, further comprising a vibration applying unit operable to apply the vibration to the measured object.

9.  The static-electricity-quantity measuring apparatus according to claim 8, wherein,

if the measured object is a part element, the vibration applying unit applies the vibration to the measured object by at least one of

individual application of applying the vibration to the individual measured obj ect transported by a manufacturing line and

entire application of applying the vibration to the manufacturing line per se on which the measured object is placed.

10. The static-electricity-quantity measuring apparatus according to claim 8, wherein,

if the measured object is a product on which a plurality of parts are mounted,

said vibration applying unit applies the vibration to the product, and

said receiving unit directs toward each region of the product.

11. The static-electricity-quantity measuring apparatus according to any of claims 8 to 10, wherein

said vibration applying unit determines at least one of amplitude and the number of vibration(s) based on a specification of at least one of said receiving unit and said measuring unit.

12. The static-electricity-quantity measuring apparatus according to any of claims 8 to 11, wherein

said vibration applying unit applies the vibration to the measured object by at least one of

direct application of applying the vibration to the supporting mount on which the measured object is placed and

indirect application of applying a sound wave to the measured object.

13. The static-electricity-quantity measuring apparatus according to any of claims 8 to 12, wherein

said vibration applying unit has a sound-wave generating unit operable to generate a sound wave, and the measured object is directly or indirectly opposed to or has a certain angle with respect to a vibrating plate possessed by said sound-wave generating unit.

14. The static-electricity-quantity measuring apparatus according to claim 13, wherein

said sound-wave generating unit has a focusing function of focusing the sound wave in accordance with the size of the measured object.

15. The static-electricity-quantity measuring apparatus according to any of claims 8 to 12, wherein said vibration applying unit has a vibrator installed at an end of the measured object and applies the vibration to the measured object by a vibration of the vibrator.

16. An electrostatic eliminator comprising the static-electricity-quantity measuring apparatus according to any of claims 1 to 15; a displaying unit operable to display the quantity of static electricity measured by the static-electricity-quantity measuring apparatus; and an electricity neutralizing unit operable to remove the static electricity electrifying the measured object.

17. A static-electricity-quantity measuring method comprising:

a receiving step of receiving a virtual electromagnetic wave generated by a vibration applied to a measured object;
a measuring step of measuring at least one of an intensity, frequency, and phase of the virtual electromagnetic wave received in the receiving step; and
a calculating step of calculating the quantity of static electricity of the measured object based on a measurement result of the measuring step.

18. The static-electricity-quantity measuring method according to claim 17, wherein, in the calculating step, the quantity of the static electricity of the measured object is calculated based on at least one of

a correspondence relational expression of the intensity of the virtual electromagnetic wave and the quantity of static electricity and
a relational table of the intensity of the virtual electromagnetic wave and the quantity of static electricity.

19. The static-electricity-quantity measuring method according to claim 17 or 18, further comprising a vibration applying step of applying the vibration to the measured object.

20. The static-electricity-quantity measuring method according to any of claims 17 to 19, further comprising a displaying step of displaying the quantity of the static electricity calculated in the calculating step.

FIG. 1

a. CASE OF LARGE MEASURED OBJECT

MEASURED OBJECT

MEASURED REGION

MEASURING EQUIPMENT

(A)

b. CASE OF SMALL MEASURED OBJECT

MEASURED OBJECT

MEASURED REGION

AVERAGE VALUE OF THIS REGION IS MEASURED

MEASURING EQUIPMENT

(B)

FIG. 2

DISTANSE DEPENDENCY OF EMASURED OBJECT

DC POWER SOURCE

MEASURED OBJECT

MEASURING EQUIPMENT

MEASURED DISTANCE

DISPLAYED VOLTAGE

MEASURED DISTANCE c·25τm APPLIED VOLTAGE 100 V

100

0    25    MEASURED DISTANCE

FIG. 3

SMALL VOLTAGE IN APPEARANCE

LINES OF ELECTRIC FORCE ARE DIRECTED TOWARD GND

GND

(A)

LARGE VOLTAGE IN APPERANCE

GND

(B)

FIG. 4

RECEIVING UNIT 2

MEASURING UNIT 3

CALCULATING UNIT 4

STATIC-ELECTRICITY-QUANTI
TY MEASURING APPARATUS

FIG. 5

VIRTUAL
ELECTROMAG
NETIC
WAVES

REFERE
NCE

REFERE
NCE

REFERENCE

VERTICAL
VIBRATIONS

(A)                    (B)                    (C)

FIG. 6

MEASURI
NG UNIT 3

RECEIVI
NG UNIT 2

CALCULAT
ING UNIT 4

10  10        20

FIG. 7

FIG. 8

FIG. 9

FIG. 10

| INTEN SITY RELIABIL ITY VALUE | 50 | 100 | 150 | 200 |
|---|---|---|---|---|
| 3 | 50 | 100 | 150 | 200 |
| 2 | 40 | 80 | 120 | 160 |
| 1 | 30 | 60 | 90 | 120 |
| 0 | 20 | 40 | 60 | 80 |

STATIC-ELECTRICITY-QUANTITY

FIG. 11

FIG. 12

EP 2 696 207 A1

FIG. 13

DISTURBING
SPACE

20

51

(A)

52

DISTURBING
SPACE

20

(B)

FIG. 14

10

522

521

52

FIG. 15

25

54

22

53

23

52

FUNCTION
GENERATOR

55

24

FIG. 16

FIG. 17

FIG. 18

FIG. 19

```
                    ┌──────────────────────┐  ST1
                    │      VIBRATION       │
                    │   APPLYING  STEP     │
                    └──────────┬───────────┘
                               │
                    ┌──────────▼───────────┐  ST2
                    │    RECEIVING  STEP   │
                    └──────────┬───────────┘
                               │
                    ┌──────────▼───────────┐  ST3
                    │   MEASURING  STEP    │
                    └──────────┬───────────┘
                               │
                    ┌──────────▼───────────┐  ST4
                    │   CALCULATING STEP   │
                    └──────────┬───────────┘
                               │
                    ┌──────────▼───────────┐  ST5
                    │   DISPLAYING  STEP   │
                    └──────────┬───────────┘
                               │
                               ▼
```

<table>
<tr><td colspan="2" align="center">**INTERNATIONAL SEARCH REPORT**</td><td colspan="2">International application No.<br>PCT/JP2012/059858</td></tr>
</table>

A.  CLASSIFICATION OF SUBJECT MATTER
*G01R29/12*(2006.01)i

According to International Patent Classification (IPC) or to both national classification and IPC

B.  FIELDS SEARCHED

Minimum documentation searched (classification system followed by classification symbols)
G01R29/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | WO 2007/055057 A1  (Japan Science and Technology Agency), 18 May 2007 (18.05.2007), paragraphs [0012] to [0016], [0022], [0035] to [0038], [0043] to [0051], [0056] to [0057], [0061]; claims 1 to 2, 8, 14 & US 2009/0221900 A1   & EP 1952763 A1 | 1-4,7-20 |
| Y | JP 2006-90998 A  (Hisashi AOYAGI), 06 April 2006 (06.04.2006), paragraphs [0001], [0004] to [0007], [0010] (Family: none) | 1-4,7-20 |
| Y | WO 2009/122485 A1  (Okayama-Ken), 08 October 2009 (08.10.2009), entire text; all drawings & US 2011/0054345 A1 | 1-4,7-20 |

☐  Further documents are listed in the continuation of Box C.  ☐  See patent family annex.

| | | |
|---|---|---|
| * | Special categories of cited documents: | "T"  later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X"  document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&"  document member of the same patent family |

| Date of the actual completion of the international search<br>02 May, 2012 (02.05.12) | Date of mailing of the international search report<br>05 June, 2012 (05.06.12) |
|---|---|
| Name and mailing address of the ISA/<br>Japanese Patent Office | Authorized officer |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001522045 A
- WO 2007055057 A
- JP 2004512528 A

### Non-patent literature cited in the description

- **H. ONOMAE.** *Kagoshima prefectural Institute of Industrial Technology research report,* 2006, 57-63
- **A. KANNO ; K. SASAGAWA ; T. SHIOZAWA ; M. TSUCHIYA.** *Optics Express,* 2010, vol. 18, 10029-10035
- **A. KUMADA ; A. IWATA ; K. OZAKI ; M. CHIBA ; K. HIDAKA.** *J. Appl. Phys.,* 2002, vol. 92, 2875
- **E. EISENMENGER ; M. HAARDT.** *Solid St. Comm.,* 1982, vol. 41, 2769-2775
- **T. MAEDA ; Y. OKI ; A. NISHIKATA ; T. MAENO.** *Trans. Inst. Elect. Engnr. Jpn. A,* 2006, vol. 126, 185-190